Europäisches Patentamt

European Patent Office

Office européen des brevets

(11) Publication number : **0 465 144 A2**

# EUROPEAN PATENT APPLICATION

(21) Application number : 91305858.2

(51) Int. Cl.⁵ : **H04L 1/00**

(22) Date of filing : 28.06.91

(30) Priority : 05.07.90 US 548155

(43) Date of publication of application :
08.01.92 Bulletin 92/02

(84) Designated Contracting States :
DE FR GB IT SE

(72) Inventor : **Eryaman, Can A.**
**Rd3 Box 596**
**Branchville, New Jersey 07826 (US)**

(74) Representative : **Buckley, Christopher Simon**
**Thirsk et al**
**AT&T (UK) LTD. AT&T Intellectual Property**
**Division 5 Mornington Road**
**Woodford Green, Essex IG8 OTU (GB)**

(71) Applicant : **AMERICAN TELEPHONE AND**
**TELEGRAPH COMPANY**
**550 Madison Avenue**
**New York, NY 10022 (US)**

(54) **Method and apparatus for interleaving symbols in a cellular transmission channel.**

(57)    Symbols ($a_1$-$a_{16}$ ; $b_1$-$b_{16}$) of a transmitted signal in a digital cellular communication channel are interleaved to reduce the burst error rate caused by channel fading. The interleaving is skewed by partitioning the frames of the data into a plurality of subsets grouped in an irregular arrangement. This interleaving scheme skews the distribution of signal symbols so that individual symbols associated with individual originating codewords are distributed unequally in various transmitted groups of symbols. The various symbol subsets are separated by increased code and time distances to counteract the effects of fading.

EP 0 465 144 A2

FIG. 7

CODEWORDS

$\{a_1, a_2, a_3, a_4, a_5, a_6, --- a_{16}\}$          $\{b_1, b_2, b_3, b_4, b_5, b_6, --- b_{16}\}$

$t \longrightarrow$

STORE, PERMUTE & INTERLEAVE SYMBOLS a & b

INTERLEAVED CODEWORDS

$\{b_1, a_1, a_2, a_3, b_2, a_4, a_5, a_6, b_3, a_7, a_8, a_9, b_4, a_{10}, a_{11}, a_{12}\}$          $\{b_5, b_6, b_7, a_{13}, b_8, b_9, b_{10}, a_{14}, b_{11}, b_{12}, b_{13}, a_{15}, b_{14}, b_{15}, b_{16}, a_{16}\}$

## Field of the Invention

This invention relates to mobile communication systems and in particular to data transmission methods and apparatus. It is particularly concerned with a scheme of interleaving transmitted data symbols to counter the effects of fading on the transmitted signal.

## Background of the Invention

Within a cellular transmission channel, radio transmission signals are subject to fading as a result of many environmental conditions. These conditions include signal reflections as a result of terrain and buildings and atmospheric conditions. The effect of these fading conditions is to distort, delay and attenuate the propagating radio signal. Degradation of fading, in mobile radiotelephone applications varies with the motion of the mobile relative to the source of transmission, and in particular, the speed of the vehicle.

Fading in cellular radio transmissions exhibits many characteristics including both bursty and long term signal degradations. As a result of these fading characteristics, significant portions of the received signal become unintelligible at the intended receiver, e.g mobile radiotelephone. In some applications, such as digital data transmissions, the distortion of just small portions of the transmitted signal may be critical to an understanding of a larger portion of the transmitted signal.

Many techniques have been developed to compensate for the fading phenomenon and include among others various diversity techniques, and in digital applications signal coding techniques such as application of error correction algorithms.

These techniques, while effective, add complexity and expense to the transmission and receiving equipment. Data integrity in a cellular radio communications system is critical due to the many cellular overhead functions, such as handoff, in maintaining communication between a base station and the mobile radiotelephone.

Interleaving techniques have been used in many applications to reduce signal transmission errors and have been applied to digital signal transmissions in many settings including magnetic recording technology and radio transmissions. These techniques may be applied to the cellular environment, however, the conventional interleaving techniques do not fully compensate for the transmission losses due to lengthy fades and fade bursts occurring in cellular transmission channels that adversely impact consecutive transmission frames. Hence, presently available interleaving techniques often do not optimize the transmission quality in a cellular transmission channel. This is due to the nature of fading encountered in a cellular transmission channel. The necessity of data integrity in at least overhead control signalling in a cellular system requires a very high quality data preservation technique.

## Summary of the Invention

Symbols of a transmitted signal in a digital cellular communication channel are interleaved to reduce the bit error rate caused by channel fading. The interleaving is skewed by partitioning the frames of the data into a plurality of subsets grouped in an irregular arrangement. This differs from various prior art interleaving schemes by skewing the distribution of signal symbols so that symbols are distributed unequally in various transmitted groups of codewords. The various symbol subsets are separated by substantial code distances to counteract the effects of fading.

One illustrative cellular transmission arrangement in a time division multiple access system (TDMA), embodying the principles of the invention, has a skew distribution specifically selected as a function of expected averages of vehicle speed and the data transmission rate to minimize error rates due to fading. This particular skew distribution advantageously assures that the channel performance is optimized. In particular, the skewed interleaving has been found to provide a time diversity action that enhances the natural time diversity action of the TDMA system to which it is applied.

## Brief Description of the Drawing

In the Drawing:
FIG. 1 is a schematic of a cellular transmission system to which the invention may be applied;
FIG. 2 is a schematic of the transmission and reception arrangement of a typical cell site;
FIG. 3 is a schematic of typical transmission and receiving equipment contained in a cell site and in a mobile transceiver unit;
FIG. 4 is a schematic of a stored program processor used in the equipment of FIG. 3;
FIGS. 5 and 6 depict a flow chart of the processes of the stored program of the processor disclosed in FIG. 4; and
FIGS. 7 and 8 depict various illustrative interleaving arrangements of transmitted symbols according to the principles of the invention.

## Detailed Description

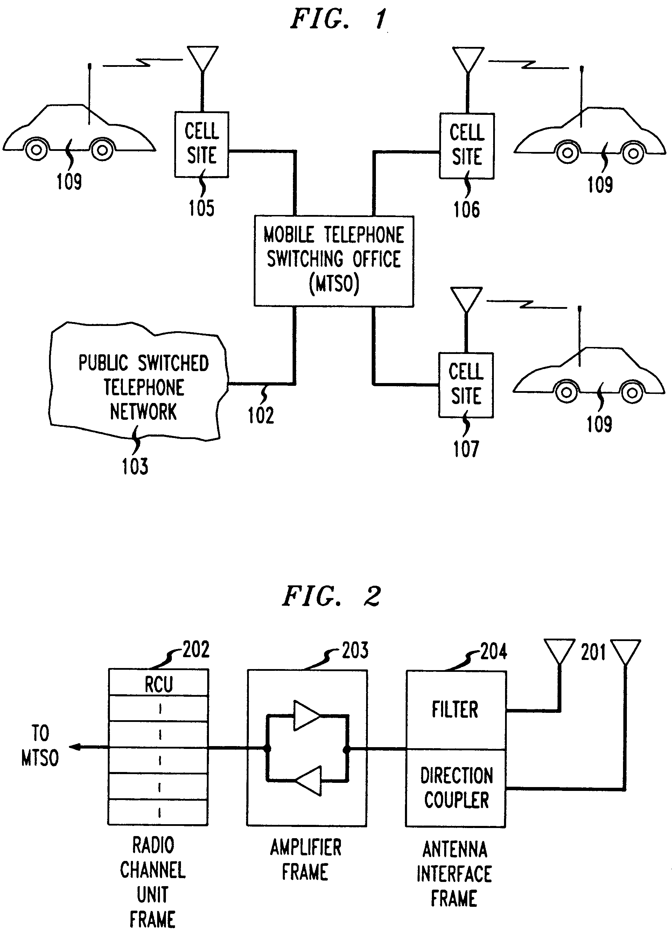

A typical TDMA cellular radiotelephone system, in which the subject invention may be applied is shown in FIG. 1. A mobile telephone switching office (MTSO) 101 is shown connected via a trunk 102 to a land public switched telephone network 103. A plurality of cell sites or base stations 105, 106 and 107 are connected to the MTSO 101 and are used to communicate with pluralities of mobile radiotelephones 109 in the areas proximate to the various cell sites.

The radio transmission system used in the mobiles and cell sites of the illustrative embodiment, as shown in FIG.2, includes an antenna array 201 of transmitting and receiving antennas, a frame 202 containing a plurality of radio transmitters and receivers, an amplifier system frame 203 a bidirectional array of signal amplifiers and a filter/coupler 204 interconnecting the amplifier frame 203 to the antenna array 201. In the illustrative embodiment a TDMA mobile transmission system is used as the operating transmission system wherein bandwidth is divided into predetermined periodic repeating time segments for each channel. The TDMA system is well known to those skilled in the cellular telephone system art and it is not believed necessary to describe this system in detail.

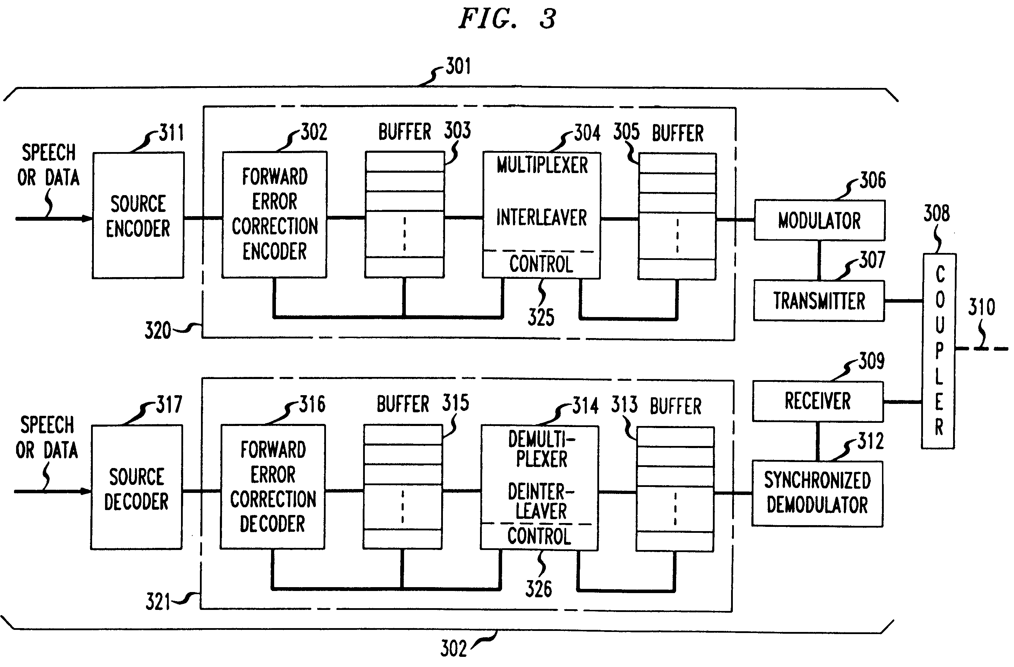

A radio transceiver suitable for use in both mobiles and in cell sites is shown in FIG. 3. A transceiver shown in schematic form includes a transmitting portion 301 and a receiving portion 302. While units 301 and 302 are shown as separate units for illustrative purposes it is to be understood that their functional equivalents may be packaged in a variety of ways which may unify various multiple functions of both or each of the portions into single packages.

Speech or data signals to be transmitted are applied to a source encoder 311 which encodes the raw input signals in to some encoded signal format for transmission processing. These encoded signals are applied to a forward error correction circuit 302 which adds redundancy to the code in order to enable the validation of reconstruction of the transmitted signal at its intended receiver. In some applications this may entail the adding of parity and correction bits to the code and in other applications more sophisticated techniques may be utilized. Signal encoding and error correction techniques are well known in the art and it is not believed necessary to discuss them in detail.

The coded signal with error correction applied is coupled to a buffer circuit 303 which temporarily stores blocks or packets of the coded signal. In a TDMA radio system this signal storage is for the purpose of saving it for transmission during its assigned time slot in the transmission channel. The buffered signal is applied to the multiplexer and interleaver 304 which inserts the signal in the proper time slot and interleaves the symbols of the original codewords to achieve robustness of transmission. The interleaved codewords are transmitted to an output storage buffer 305 which applies them to a modulator 306. The modulated codeword is coupled to a radio transmitter 307 which is connected in turn to a coupler 308 and is further connected, via lead 310, to a transmitting antenna.

The receive portion 302 of the transceiver parallels the signal processing functions described above with respect to the transmitter 301. The antenna is connected by the coupler 308 to the radio receiver 309. The received signal is demodulated in the demodulator 312 and applied to the storage buffer 313. The signal is de-interleaved in the demultiplexer and deinterleaver 314 and applied to buffer 315. The error correction circuit 316 detects and corrects errors in the received signal and applied it to the source decoder 317.

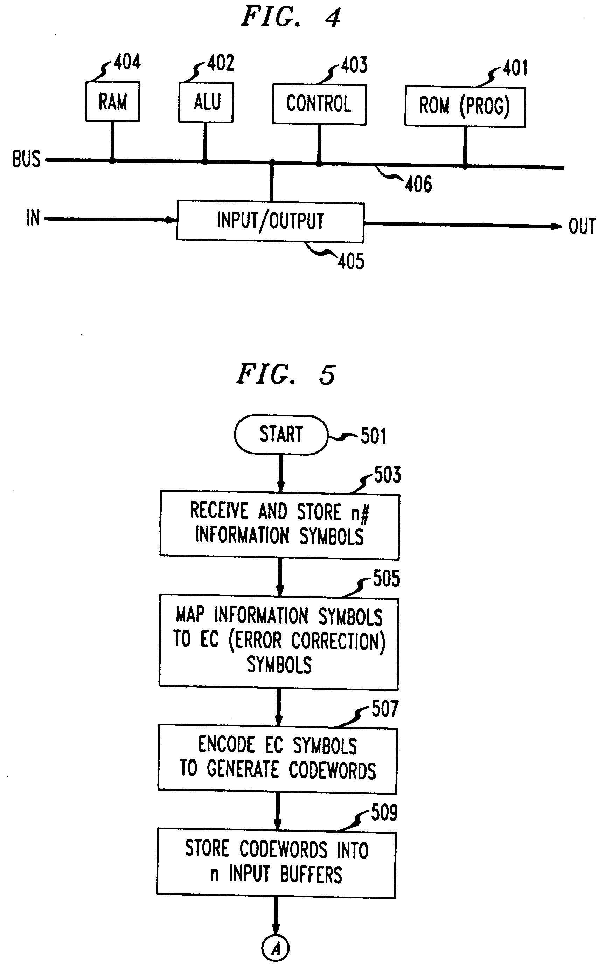

The error correction, interleaving and multiplexing may be performed by a single processing circuit comprised in a single package as shown by the dotted line boxes 320 and 321 in FIG. 3. As shown, each includes respectively a control circuit 325 and 326 which is a stored program type controller in the illustrative embodiment. This signal processing package includes a digital signal processor as shown in schematic form in FIG. 4. A controlling stored program is included in the ROM storage 401 and operatively controls the central processing unit 402. A control unit 403 permits external control signals to be applied to modify the stored program if needed. RAM storage 404 is provided for processing purposes. An inpud/output circuit 405 allows the entrance and egress of the signals processed. All these units are coupled to an interconnecting bus circuit 406.

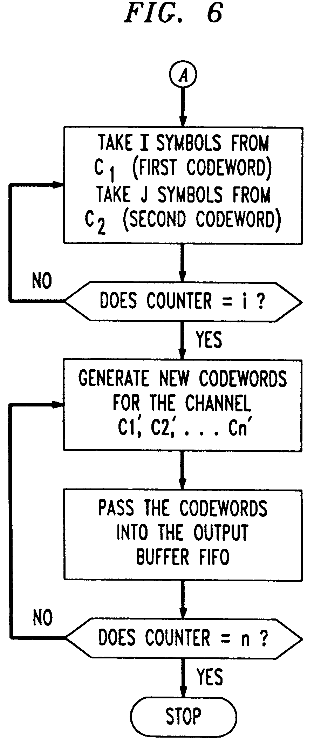

The controlling algorithm embodied in the stored program is schematically illustrated by the flow chart shown in FIGS. 5 and 6. This flow chart may be considered analogous to a circuit schematic in that the program instructions to implement the flow chart may be written by those skilled in the art much as circuit components values may be selected by those skilled in the art for a given circuit schematic.

The flow process is started (block 501) in response to generation of a message for transmission. The information symbols of the message are received and initially stored in a encoding circuit (block 503). The information symbols are transformed by mapping techniques into an error corrected form by forward error correction techniques (block 505). Such a mapping transformation generates error correction symbols (block 507) and may include adding parity and correction symbols to the information symbols or may use sophisticated techniques such as erasures, etc. The error corrected symbols are used to generate originating codewords with predetermined lengths of symbols (block 507). The originating codewords are stored into the input buffers prior to their multiplexing (block 509).

Symbols in precise numbers are taken from each codeword for interleaving purposes as shown in FIG. 6, (block 601) I symbols are taken from a first codeword and J symbols are taken from a second codeword (block 601). This is repeated and continued for a definite count that establishes the interleaving depth and rank of the interleaved codeword (block 603). When the preset count is reached the new interleaved codeword for transmission has been generated (block 605). This interleaved codeword is inserted into a buffer storage for subsequent transmission (block 607). These interleaved code words are continuously generated until a number of the interleaved codewords are ready for transmission and all the symbols of the original codewords are all interleaved properly (block 609). With the codewords properly interleaved in a skew distribution the algorithm has been fully cycled and is ready to begin again at the start terminal 501.

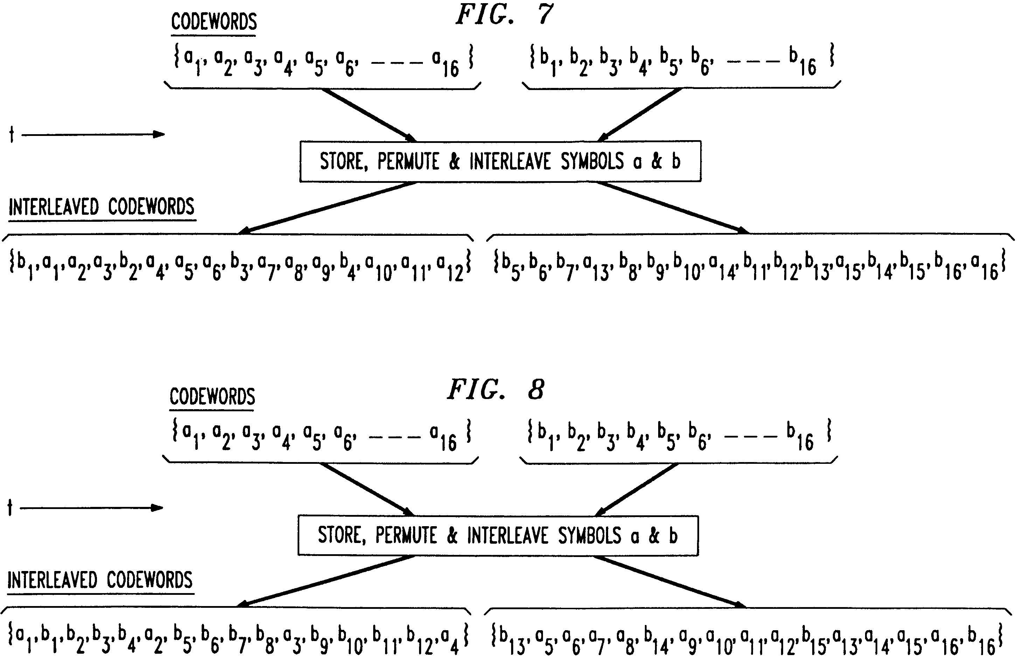

A typical example of a codeword interleaved to depth two, rank three, is shown in FIG. 7. Two originating codewords, A and B each comprising 16 symbols are shown as skew interleaved into interleaved codewords Ab and Ba with the rank of three symbols. This depth/rank of skew interleaving permits recovery of the original codeword even if three successive symbols are destroyed by a fade.

Interleaving to a depth of two, rank four, for the same length originating codewords A and B is illustrated in FIG. 8. While FIGS. 7 and 8 show two specific examples of skew interleaving many other combinations will suggest themselves to those skilled in the art without departing from the spirit and scope of the invention.

## Claims

1. A data transmission system, CHARACTERISED BY an input for accepting source signals encoded by a plurality of symbols, storage circuitry (303) for storing individual symbols, interleaving circuitry (304) for distributing symbols of first and second originating codewords into subsequent codewords with a skewed distribution of grouped symbols having a ratio of N to one symbols, wherein the N symbols are selected from one originating codeword and the one symbol is from the other of the originating codeword, and transmission circuitry (305-308) for transmitting the subsequent codewords.

2. A system as claimed in claim 1, comprising stored program control of the interleaving circuitry having first means for removing N symbols from one originating codeword and one symbol from another originating codeword, and second means for repeating the operations of the first means until a transmission codeword length is generated.

3. A system as claimed in claim 1 or 2, comprising storage circuitry (305) for storing interleaved codewords commensurate with a selected depth of interleaving, and coupling means (308) for applying the interleaved codewords to the transmission circuitry.

4. A system as claimed in claim 1, 2 or 3, wherein the subsequent codewords have a depth of at least two and a rank of three.

5. A system as claimed in claim 1, 2 or 3 wherein the subsequent codewords have a depth of at least two and a rank of four.

6. A method for processing data signals for radio transmission in a fading medium, comprising the steps of storing an N number of information symbols, generating originating codewords from the information symbols, storing the codewords into $n$ distinct slots, selecting I symbols from a first codeword, selecting J symbols from a second codeword, performing each step to achieve a desired depth and rank of skewed interleaving, assembling the selected symbols and generating a new codeword, and storing $n$ of the new codewords in a storage means (305) for subsequent transmission.

7. A method as claimed in claim 6, comprising the steps of placing the originating codewords into an error correcting form, and encoding the error correcting symbols into a codeword form.

8. A method as claimed in claim 6 or 7, wherein the originating codewords are interleaved to a depth of two and a rank of three.

9. A method as claimed in claim 6 or 7, wherein the originating codewords are interleaved to a depth of two and a rank of four.

10. A mobile radio telephone transceiver, CHARACTERISED BY means for accepting and storing information N symbols from a data source, means for generating originating codewords from the information symbols and storing the originating codewords into $n$ storage slots, means for repeatively selecting I symbols from a first originating codeword and J symbols from a second originating codeword for I times, and means for assembling the selected symbols into new interleaved codewords for radio transmission.

11. A transceiver as claimed in claim 10, comprising means for storing the new codewords into $n$ storage slots prior to transmission.

12. A transceiver as claimed in claim 10 or 11, comprising means for placing the originating codewords into an error correcting form, and means for encoding the error correcting symbols into a codeword form.

13. A transceiver as claimed in claim 10, 11 or 12, wherein, in operation, the new interleaved codewords are interleaved to a depth of at least two with a rank of three.

14. A transceiver as claimed in claim 10, 11 or 12, wherein, in operation, the new interleaved codewords are interleaved to a depth of at least two with a rank of four.

## FIG. 1

## FIG. 2

FIG. 3

## FIG. 4

RAM 404    ALU 402    CONTROL 403    ROM (PROG) 401

BUS   406

IN →   INPUT/OUTPUT   → OUT

405

## FIG. 5

START — 501

RECEIVE AND STORE n#
INFORMATION SYMBOLS — 503

MAP INFORMATION SYMBOLS
TO EC (ERROR CORRECTION)
SYMBOLS — 505

ENCODE EC SYMBOLS
TO GENERATE CODEWORDS — 507

STORE CODEWORDS INTO
n INPUT BUFFERS — 509

(A)

## FIG. 6

(A)

↓

TAKE I SYMBOLS FROM
$C_1$ (FIRST CODEWORD)
TAKE J SYMBOLS FROM
$C_2$ (SECOND CODEWORD)

↓

NO ← DOES COUNTER = i ?

YES

↓

GENERATE NEW CODEWORDS
FOR THE CHANNEL
$C1', C2', \ldots Cn'$

↓

PASS THE CODEWORDS
INTO THE OUTPUT
BUFFER FIFO

↓

NO ← DOES COUNTER = n ?

YES

↓

STOP

FIG. 7

CODEWORDS

$\{a_1, a_2, a_3, a_4, a_5, a_6, --- a_{16}\}$     $\{b_1, b_2, b_3, b_4, b_5, b_6, --- b_{16}\}$

t ⟶

STORE, PERMUTE & INTERLEAVE SYMBOLS a & b

INTERLEAVED CODEWORDS

$\{b_1, a_1, a_2, a_3, b_2, a_4, a_5, a_6, b_3, a_7, a_8, a_9, b_4, a_{10}, a_{11}, a_{12}\}$     $\{b_5, b_6, b_7, a_{13}, b_8, b_9, b_{10}, a_{14}, b_{11}, b_{12}, b_{13}, a_{15}, b_{14}, b_{15}, b_{16}, a_{16}\}$

FIG. 8

CODEWORDS

$\{a_1, a_2, a_3, a_4, a_5, a_6, --- a_{16}\}$     $\{b_1, b_2, b_3, b_4, b_5, b_6, --- b_{16}\}$

t ⟶

STORE, PERMUTE & INTERLEAVE SYMBOLS a & b

INTERLEAVED CODEWORDS

$\{a_1, b_1, b_2, b_3, b_4, a_2, b_5, b_6, b_7, b_8, a_3, b_9, b_{10}, b_{11}, b_{12}, a_4\}$     $\{b_{13}, a_5, a_6, a_7, a_8, b_{14}, a_9, a_{10}, a_{11}, a_{12}, b_{15}, a_{13}, a_{14}, a_{15}, a_{16}, b_{16}\}$

EP 0 465 144 A2